# EUROPÄISCHE PATENTANMELDUNG

(11) **EP 0 551 565 A2**
(43) Veröffentlichungstag der Anmeldung: **21.07.1993**
(21) Anmeldenummer: 92115376.3
(22) Anmeldetag: 09.09.1992
(51) Int. Cl.: H04M 3/30, H03K 17/00

(54) **Ferntrenneinrichtung**

(30) Priorität: 11.01.1992 DE 4200775
(71) Anmelder: KRONE Aktiengesellschaft, D-14167 Berlin (DE)
(72) Erfinder: Hönl, Robert, Dr., W-1000 Berlin 31 (DE); Radmer, Andreas, Dipl.-Ing., W-1000 Berlin 39 (DE)

(57) **Zusammenfassung**

Ferntrenneinrichtungen werden benötigt, um am Übergabepunkt des Telefonnetzes eines Betreibers zu dem Netz eines anderen Betreibers feststellen zu können, in welchem Teil der gekoppelten Netze ein Fehler aufgetreten ist, d.h. die Netze zu Meßzwecken voneinander gleichspannungsmäßig zu separieren.

Bekannt sind Ferntrenneinrichtungen auf der Basis von TRIACS und MOS-FETS, wobei eine einheitliche Schaltschwelle benutzt wird. Werden gesteuerte Siliziumgleichrichter als elektronische Schalter benutzt, so werden die Schalter durch ein Koppelglied miteinander verbunden, um Wahlimpulse vom Telefon zur Vermittlungsstelle übertragen zu können und Schalter mit unempfindlichen Steueranschlüssen zu verwenden.

Der Einsatz selbstsperrender MOS-FETs vom Anreicherungstyp ermöglicht erfindungsgemäß eine hohe Einschaltschwelle und eine niedrige Ausschaltschwelle, so daS das übliche Meßverfahren der Spannungsabsenkung verwendet werden kann. Es ist auch möglich, die Einschaltschwelle von der Polarität der Spannung abhängig zu machen.

## Beschreibung

Die Erfindung betrifft eine Ferntrenneinrichtung gemäß dem Oberbegriff des Anspruches 1.

Im Zuge der Privatisierung von Fernmeldeanschlüssen können Teilnehmer ab einem bestimmten Punkt, dem sogenannten Übergabepunkt, frei über ihr privates Telefon oder Telefonanlage verfügen. Die Wartung derartiger privater Telefonanlagen befindet sich dabei in den Händen des privaten Betreibers und liegt nicht im Verantwortungsbereich des Netzbetreibers. Im Fall einer Störung ist es daher für den Netzbetreiber hilfreich, möglichst einfach feststellen zu können, ob der Fehler in seinem Netz oder in dem privaten Telefonsystem aufgetreten ist, da der Netzbetreiber nur für die Behebung von Fehlern vor dem Übergabepunkt zuständig ist. Fehler die hinter den Übergabepunkt auftreten, müssen von dem Teilnehmer selbst behoben werden. Diese Lokalisation von Fehlern von einem zentralen Prüfplatz aus wird durch Ferntrenneinrichtungen ermöglicht, die am Übergabepunkt in die Leitung eingefügt werden. Derartige Ferntrenneinrichtungen bestehen im wesentlichen aus elektronischen Schaltern, die ein Abtrennen des Teilnehmers zu Meßzwecken gestatten. Im normalen Telefonbetrieb sind die Schalter geschlossen. Im Fehlerfall wird eine Messung von der Fernmelde-Entstörstelle aus mit einer Prüfeinrichtung durchgeführt, wobei mittels eines elektronischen Signales bzw. einer Spannung der Schalter geöffnet wird, so daß eine Prüfung der Teilnehmerleitung ohne Teilnehmer durchgeführt werden kann. Die Messungen sind im allgemeinen reine Gleichspannungsmessungen, die zur Bestimmung der Widerstände dienen.

Bekannt sind verschiedene Schaltungen für Ferntrenneinrichtungen, die sich durch ihre Schaltungskonzeption unterscheiden. Die eine Art von Schaltungen benutzt MOS-Feldeffekttransistoren (MOS-FET) als Schaltelemente, während die andere Art der Schaltungen mit gesteuerten Siliziumgleichrichtern als Schaltelemente arbeitet.

Ferntrenneinrichtungen, die mit gesteuerten Siliziumgleichrichtern arbeiten, sind in der DE-39 23 981 und der EP-0168840 beschrieben. Als gesteuerte Siliziumgleichrichter kommen Thyristoren oder Triacs zum Einsatz, welche über zwei Hauptanschlüsse und einem Gate-Anschluß verfügen . Mit Hilfe eines Zündimpulses, der dem Gate zugeführt wird, können diese Bauelemente in einen niederohmigen Zustand gebracht werden. Dieser hält solange an, bis der Strom, der über den Schalter fließt, einen bestimmten Wert, den sogenannten Haltestrom unterschreitet. Die Ansteuerschaltung besteht meistens aus einem Widerstand und einer bzw. zwei Zener-Dioden, wobei durch die Zenerdiode die Schaltspannung eingestellt werden kann.

Zusätzlich wird über die Schalter ein Wechselstrom-Überbrückungsweg gelegt, der die Übertragung der Rufwechselspannung ermöglicht. Der Übertragungsweg enthält einen Kondensator mit einer relativ hohen Kapazität von 10-20 Mikrofarad. Diese Kapazität bereitet in Zusammenhang mit dem in vielen Ländern üblichen Impulswahlverfahren ( IWF ) Probleme, weil ein schnelles Ansprechen der Schalter, beim Impulswahlverfahren üblicherweise im 50-60 Millisekunden-Takt, verhindert wird. Daher muß bei bisherigen Ferntrenneinrichtungen die Kapazität im Überbrückungsweg so klein wie möglich gehalten werden. Desweiteren müssen Schalter mit empfindlichen Steueranschlüssen verwendet werden. Um nun ein unbeabsichtigtes Schließen der Schalter mit ihren empfindlichen Steueranschlüssen zu verhindern, müssen zusätsliche, schaltungstechnische Maßnahmen getroffen werden. Um beispielsweise kurzzeitige Spannungsimpulse kurzzuschließen, werden Kondensatoren zwischen dem Steueranschluß und einem Hauptanschluß eines Schalters gelegt.

Anstelle von gesteuerten Siliziumgleichrichtern können auch MOS-Feldeffekttransistoren als Schalter in einer Ferntrenneinrichtung verwendet werden. Wesentliche Vorteile von MOS-FETs sind der geringe ohmsche Widerstand im eingeschalteten Zustand und der hochohmige Steueranschluß. Durch den geringen ohmschen Widerstand ergibt sich ein besseres Übertragungsverhalten als bei gesteuerten Siliziumgleichrichtern. Bei geeigneter Ansteuerung des Steueranschlusses kann der Rufwechselstrom über den MOS-Transistor übertragen werden, wodurch der bei Ferntrenneinrichtungen mit gesteuerten Siliziumgleichrichtern notwendige Wechselstrom-Überbrückungsweg entfällt.

In der US 4.635.084 und in der Druckschrift Siliconix " Low Power Discretes Data Book, 1989, S.9-152f " werden Ferntrenneinrichtungen beschrieben, welche selbstleitende MOS-FETs vom Veramungstyp ( Depletion-Type ) als Schalter verwenden. Nachteilig dabei ist, daß diese Ferntrenneinrichtung durch einen Spannungsimpuls, der größer ist als die Speisespannung, aktiviert wird. Die Fernsprechleitung wird damit am Übergabepunkt für eine kurze Zeitspanne aufgetrennt, in der die Messung durchgeführt werden kann. Dabei wird die Zeitspanne von einer Zeitkonstanten bestimmt, d.h. sie ist fest vorgegeben. Das Standard-Meßverfahren durch Absenken der Spannung ist somit nicht durchführbar.

Der Erfindung liegt die Aufgabe zugrunde, eine Ferntrenneinrichtung für Teilnehmerleitungen der gattungsgemäßen Art zu entwickeln, welche keine Probleme bei der Übertragung von Wahlimpulsen zeigt und welche es ermöglicht, die üblichen Meßverfahren durchzuführen.

Die Lösung der Aufgabe ergibt sich aus den kennzeichnenden Merkmalen des Anspruches 1. Eine nebengeordnete Lösung ergibt sich aus den kennzeichnenden Merkmalen des Anspruches 4. Arbeiten die Ferntrenneinrichtungen mit gesteuerten Siliziumgleichrichtern, so werden die beiden Ansteuerzweige, welche aus jeweils einer Zenerdiode und einem Widerstand gebildet werden, erfindungsgemäß mit einem Koppelglied verbunden. Das Koppelglied besteht aus der Serienschaltung einer Kapazität mit einem Widerstand. Die erfindungsgemäße Verbindung der beiden Ansteuerzweige durch das Koppelglied sorgt für das schnelle Ansprechen der Siliziumgleichrichter. Dadurch ist es möglich, hohe Kapazitäten im Wechselstrom-Überbrückungsweg einzusetzen, ohne daß Störungen bei der Übertragung von Wahlimpulsen auftreten. Zusätzlich wird durch die große Kapazität im Überbrückungsweg im Zusammenhang mit den Leitungs- und Abschlußwiderständen ein Hochpaß gebildet, der die Übertragung von digitalen Signalen ermöglicht. Weiterhin erlaubt die erfindungsgemäße Ansteuerschaltung die Verwendung von Schaltern mit weniger empfindlichen Steuereingängen, so daß zusätzliche Bauteile, die das unbeabsichtigte Schließen der Schalter verhindern sollen, entfallen können.

Werden Thyristoren als Schalter benutzt, so müssen parallel zu den Thyristoren Dioden geschaltet werden, die den vom Teilnehmer wegfließenden Strom führen. Da die Ferntrenneinrichtung polungsunabhängig arbeiten muß, sind für jeden Leitungsweg je ein Thyristor und eine Diode vorgesehen. Entsprechend der Polung der Ferntrenneinrichtung übernimmt in dem einen Leitungsweg der Thyristor, im dem anderen die Diode den Stromfluß. Kommen Triacs als Schalter zum Einsatz, so können die Dioden entfallen, da die Triacs den Strom in beide Richtungen leiten.

Werden MOS-FETs als Schalter in den Ferntrenneinrichtungen benutzt, so kommen erfindungsgemäß selbstsperrende MOS-FETs vom Anreicherungstyp ( Enhancement-Type ) zum Einsatz. Jeder MOS-FET Schalter wird durch einen Spannungsteiler angesteuert, welcher die Einschaltschwelle definiert. Die niedrige Ausschaltschwelle der Ferntrenneinrichtung wird durch zusätzliche MOS-FETs erreicht, welche in Verbindung mit einem seriellen niederohmigen Widerstand den Spannungsteiler der Einschaltschwelle teilweise überbrücken. Somit wird ein Hysterese-Verhalten der Steuerschaltung erreicht. Ein Mos-FET Schalter besteht aus mindestens einem und höchstens zwei MOS-FET Zweigen, welche wiederum einen oder zwei MOS-FETs enthalten. Besteht ein MOS-FET Schalter aus zwei Zweigen, so enthält der eine Zweig n-Kanal und der andere Zweig p-Kanal Mos-FETs, wobei die Zweige parallel geschaltet sind. Für jeden Zweig ist ein Spannungsteiler vorgesehen, wobei die für das Hysterese-Verhalten notwendige Überbrückung nur den Spannungsteiler eines Zweiges des jeweiligen Schalters betrifft. Die Einschaltspannung kann einige Volt unter der Speisespannung des Fernmeldenetzes liegen, während die Ausschaltspannung unter 10 Volt liegen kann. Der Einsatz von Kondensatoren bewirkt ein verzögertes Ausschalten der MOS-FETs und ermöglicht so die Übertragung von Rufwechselströmen. Besonders vorteilhaft ist, daß durch die Verwendung von MOS-FETs des Anreicherungstyps dasselbe Meßverfahren durch Absenken der Steuerspannung wie bei den Ferntrenneinrichtungen mit gesteuerten Siliziumgleichrichtern verwendet werden kann. Die n-Kanal Zweige können durch den Einsatz von DC/DC-Wandlern eingespart werden. Dabei sind komplementäre Schaltungen eingeschlossen.

Steht für Prüfzwecke nur eine Meßspannung zur Verfügung, so ist es vorteilhaft, wenn die Ferntrenneinrichtung auch mit einer Spannung angesteuert werden kann. Dies wird durch das Verpolen eines elektronischen Schalters in einer Ader erreicht.Die Schaltfunktion der Ferntrenneinrichtung kann dann durch das Verpolen der Meßspannung erreicht werden, wenn diese unter der Schaltspannung für die Schalter liegt. Dies kann für beide Arten der Ferntrenneinrichtung, d.h. Siliziumgleichrichter oder MOS-FETs als Schalter, erreicht werden.

Weitere vorteilhafte Ausgestaltungen der Erfindung ergeben sich aus den Unteransprüchen.

Die Erfindung ist nachfolgend anhand mehrerer in den Zeichnungen dargestellter Ausführungsformen beschrieben. Es zeigen:
- Fig. 1: Das Schema eines Teilnehmeranschlusses,
- Fig. 2: eine Ferntrenneinrichtung mit gesteuerten Siliziumgleichrichtern,
- Fig. 3: das Verhalten einer Ferntrenneinrichtung mit gesteuerten Siliziumgleichrichtern mit und ohne Koppelglied bei Impulswahl,
- Fig. 4: eine Ferntrenneinrichtung mit MOS-FET Schaltern,
- Fig. 5: eine vereinfachte Teilschaltung der Schaltung gemäß Fig. 4,
- Fig. 6: eine zweite Ausführungsform einer Ferntrenneinrichtung mit MOS-FET Schaltern,
- Fig. 7: eine dritte Ausführungsform einer Ferntrenneinrichtung mit MOS-FETs und DC/DC-Wandlern.
- Fig. 8: eine Ferntrenneinrichtung mit gesteuerten Siliziumgleichrichtern und verpolten elektonischen Schaltern und
- Fig. 9: eine Ferntrenneinrichtung mit MOF-FET Schaltern, deren Schalter gegenseitig verpolt sind.

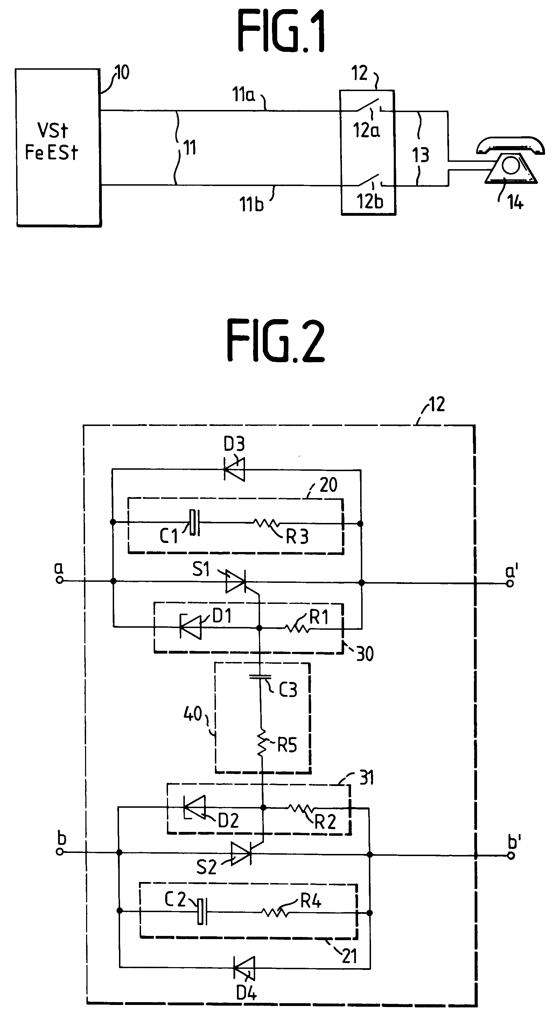

Fig. 1 zeigt einen Teilnehmeranschluß, bei dem von einer Vermittlungsstelle 10, die zur Vereinfachung auch die Fernmelde-Entstörstelle beinhaltet, eine Teilnebmerleitinng 11 (bestehend aus zwei Leitungen 11a und 11b) zum Übergabepunkt führt, an dem sich eine Ferntrenneinrichtung 12 befindet. Hinter dem Übergabepunkt 12 befindet sich das private Netz 13 mit seinen Endeinrichtungen 14 . Die Ferntrenneinrichtung 12 besteht im wesentlichen aus zwei elektronischen Schaltern 12a, 12b, die ein Abtrennen des Teilnehmers gestatten. Diese Schalter werden durch eine geeignete Ansteuerspannung spannungsabhängig angesteuert. Die Schaltspannung liegt unter der Speisespannung der Teilnehmerleitung 11, so daß die Schalter im normalen Telefonbetrieb geschlossen sind. Im Fehlerfall wird von der Vermittlungsstelle 10 aus eine Messung mit einer Prüfeinrichtung durchgeführt, die mit zwei Spannungen arbeitet. Eine Spannung davon liegt über, während die andere unter der Schaltspannung liegt. Durch eine Spannungsabsenkung unter die Schaltschwelle wird der Schalter geöffnet, und es kann eine Prüfung der Teilnehmerleitung ohne Teilnehmer durchgeführt werden.

Fig. 2 zeigt eine bevorzugte Ausführungsform einer Ferntrenneinrichtung, bei der Thyristoren S₁, S₂, welche in die Leitungen A-A' (11a) und B-B' (11b) geschaltet sind, als Schalter verwendet werden. Um die Polungsunabhängigkeit der Ferntrenneinrichtung herzustellen, sind Dioden D3 und D4 parallel zu den Thyristoren S1 und S2 geschaltet, wobei die Durchlaßrichtung der Dioden D3, D4 entgegengesetzt zur Durchlaßrichtung der Thyristoren S1, S2 ist. Entsprechend der Polung der Ferntrenneinrichtung übernimmt in einem Leitungszweig der Thyristor, im anderen die Diode den Stromfluß. Ist z.B. die Ader 11a der Fernmeldeleitung positiv gegenüber der Ader 11b, so fließt der Speisestrom während des Betriebes über den Thyristor S1 und die Diode D4. Möglich ist auch die erfindungsgemäße Ausführung einer Ferntrenneinrichtung mit Triacs. Dabei entfallen die Dioden D3,D4, da ein Triac den Strom in beide Richtungen leitet. Parallel zu den Schaltern sind die Überbrückungswege 20,21 geschaltet. Die spannungsabhängige Einschaltcharakteristik der Thyristoren S1,S2 wird durch die Ansteuerzweige 30,31 erreicht. Um das schnelle Ansprechen der Thyristoren S1,S2 bei Impulswahl zu erreichen, werden beide Ansteuerzweige 30,31 mit einem Koppelglied 40 verbunden.

Beim Impulswahlverfahren werden im Telefon 14 die Wahlimpulse dadurch erzeugt, daß ein im Telefon befindlicher Wahlimpulsschalter im Takt der Impulse geöffnet und geschlossen wird. Bei geschlossenem Wahlimpulssshalter muß Strom fließen, damit die Wahlimpulse von der Vermittlungsstelle 10 erkannt werden könne. Deshalb muß der entsprechende Thyristor der Ferntrenneinrichtung 12 während eines Wahlimpulses geschlossen sein um einen Stromfluß zu ermöglichen. Beim Öffnen des Wahlimpulsschalters im Telefon wird der Thyristor ebenfalls öffnen, da der Haltestrom unterschritten wird. Ein Schließen des Thyristors muß ca. alle 100 Millisekunden erfolgen. Dies wird beim Fehlen des Koppelgliedes 40 durch den Kondensator im Überbrückungszweig verhindert, weil dieser während des letzten Impulses über den leitenden Thyristor entladen wurde und sich während der Öffnungszeit des Wahlimpulsschalters, die ca. 30-40 Millisekunden beträgt, noch nicht wieder auf die Schaltspannung aufladen konnte. Die Zeitkonstante zum Aufladen des Kondensators C1,C2 im Überbrückungsweg 20,21 liegt, bedingt durch das hochohmige Telefon, zwischen 20 und 100 Sekunden. Die Zeitkonstante des Koppelgliedes 40 ist kleiner 10 Millisekunden, so daß der Kondensator C3 des Koppelgliedes 40 den Zündimpuls für den Thyristor S1,S2 liefern kann, wenn sich der Wahlimpulsschalter im Telefon schließt. Das Koppelglied 40 nutzt damit den nach dem Öffnen des Wahlimpulsschalters entstehenden Ladestrom der Kondensatoren C1,C2 aus, in dem ein Teil dieses Stromes im Kondensator C3 des Koppelgliedes 40 gespeichert wird und als Zündenergie für den Thyristor S1, S2 zur Verfügung steht, wenn der Wahlimpulswahlschalter wieder schließt.

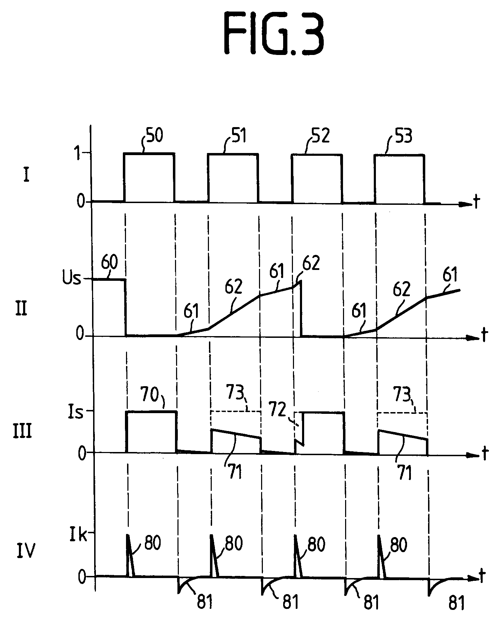

Fig. 3 zeigt das Verhalten der Ferntrenneinrichtung einmal mit Koppelglied 40 (gestrichelte Linie) und einmal ohne Koppelglied 40 (durchgezogene Linie) bei Impulswahl. Dabei ist das Potential der Ader 11a positiv gegenüber demjenigen der Ader 11b. Fig. 3a zeigt die Zustände des Wahlimpulsschalters im Telefon 14, Fig. 3b zeigt den zeitlichen Verlauf der Ladespannung am Kondensator C1 des Überbrückungsweges 20, Fig. 3c gibt den zeitlichen Verlauf des Schleifenstromes wieder und in Fig. 3d ist der Strom im Koppelglied 40 dargestellt.

Wird die Schaltung ohne das Koppelglied 40 betrieben, so war der Kondensator C1 vor dem ersten Wahlimpuls 50 auf die Schaltspannung aufgeladen, die durch die Diode D1 bestimmt wird. Der Thyristor S1 kann zünden und es fließt ein konstanter Schleifenstrom 70 während der Impulsdauer. Im Anschluß an den Wahlimpuls 50 läßt sich der Kondensator C1 langsam wieder auf. Die Zeitkonstante ist jedoch sehr hoch, weil der Widerstand des Telefons zwischen den Impulsen 100 K-Ohm bis einige MegaOhm betragen kann. Deshalb hat die Spannung 61 am Kondensator zu Beginn des nächsten Wahlimpulses 51 noch nicht die Schaltspannung erreicht und der Thyristor S1 kann nicht gezündet werden. Während des Impulses 51 fließt ein erhöhter Ladestrom 71, weil das Telefon für die Zeit eines Wahlimpulses niederohmig ( typisch ungefähr 300 Ohm ) wird. Durch den erhöhten Ladestrom steigt die Spannung am Kondensator C1, 62 entsprechend schnell an. Zu Beginn des dritten Impulses 52 hat die Spannung noch nicht die Schaltspannung erreicht, so daß der Thyristor S1 nicht zu Beginn des Impulses, sondern erst zu einem späteren Zeitpunkt 72 gezündet wird. Durch die Entladung des Kondensators C1 entsprechen die Verhältnisse beim vierten Impuls wieder denjenigen beim zweiten Impuls 51.

Das Verhalten der Schaltung mit einem Koppelglied 40 ist in der Fig. 3 a bis d durchgezogen eingezeichnet. Beim ersten Impuls 50 wird der Thyristor S1 durch die Ladespannung des Kondensators C1 zünden. Beim zweiten Impuls 51 erreicht die Ladespannung nicht für eine Zündung aus. Der Zündimpuls 80 wird deshalb vom Koppelglied 40 geliefert, das sich zwischen den Impulsen aufgeladen hat.

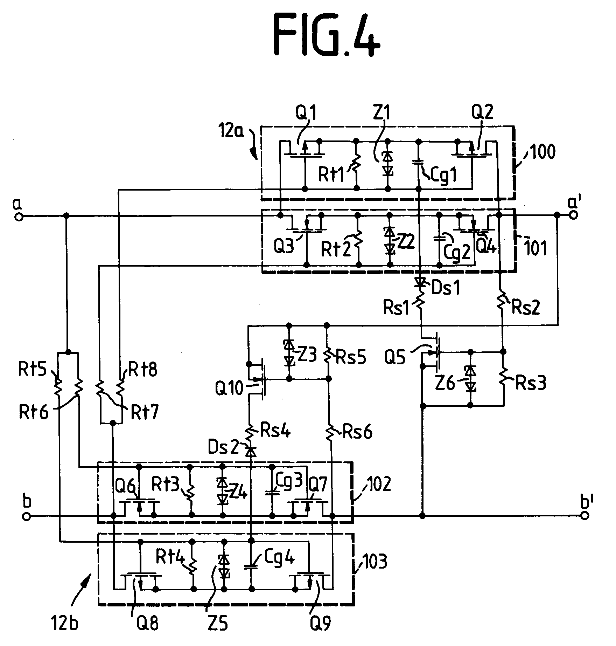

Fig. 4 zeigt die bevorzugte Ausführungsform der Erfindung bei der die Schalter 12a, 12b durch MOS-FETs gebildet werden. Der MOS-FET Schalter 12a umfaßt die zwei MOS-FET-Zweige 100, 101, während der MOS-FET-Schalter 12b durch die MOS-FET-Zweige 102, 103 gebildet wird. Dabei enthalten die MOS-FET-Zweige 100, 103 p-Kanal-Mos-Fets und die zweige 101, 102 n-Kanal MOS-FETs. Jeder MOS-FET-Zweig besteht aus einem MOS-FET-Paar (Q1,Q2), (Q3,Q4), (Q6,Q7) und (Q8,Q9), wobei jeweils die Gate- und Source-Anschlüsse eines MOS-FET Paares miteinander verbunden sind. Die Kanal-Substratdioden sind gegeneinander geschaltet, so daß der Strom nur über die Kanäle der MOS-Transistoren zwischen Teilnehmer und Vermittlungsstelle fließen kann. Denkbar ist auch statt der Source- die Drain-Anschlüsse miteinander zu verbinden, um zu verhindern, daß der Strom über die Substrat-Dioden fließen kann. Die p-Kanal Zweige 100,103 übernehmen jeweils den Strom der zum Teilnehmer hinfließt, während die n-Kanal Zweige 101,102 den Strom vom Teilnehmer zur Vermittlungsstelle übernehmen. Da jeder Schalter 12a, 12b sowohl einen n- als auch ein p-Kanal Zweig enthält, arbeitet die Schaltung polungsunabhängig.

Die Ansteuerung der MOS-FET-Zweige 100,101,102 und 103 erfolgt über je einen Spannungsteiler (Rt1,Rt8), (Rt2,Rt7), (Rt3,Rt6) und (Rt4,Rt5). Der Widerstand Rt8 des Spannungsteilers des Zweiges 100 kann durch einen MOS-FET Q5 mit einem seriellen Widerstand Rs1 und einer Diode Ds1 überbrückt werden. Das Gate des Ansteuerungs-MOS-FETs Q5 wird durch den Spannungsteiler Rs2, Rs3 angesteuert. Dasselbe gilt für den Zweig 103, hier überbrückt ein Ansteuerungs-MOS-FET Q10 mit einem seriellen Widerstand Rs4 und einer Diode Ds2 dem Widerstand Rt5 im durchgeschalteten Zustand des MOS-FETs. Das Gate von Q10 ist mit einem Spannungsteiler, gebildet aus den Widerständen Rs5 und Rs6 beschaltet. Zur Spannungsbegrenzung sind zwischen den Source und den Basis-Leitungen der jeweiligen Zweige 100, 101, 102 und 103 Zenerdioden-Paare Z1, Z2, Z4 und Z5 geschaltet. Dasselbe gilt für die MOS-FETs Q5 und Q10, dort sind es die Zenerdioden-Paare Z6 und Z3. Die Beschaltung und die Spannungsteiler sind so dimensioniert, daß sich eine hohe Einschaltspannung und eine niedrige Ausschaltspannung ergibt. Die Einschaltspannung kann einige Volt unter der Speisespannung des Fernmeldenetzes liegen, während die Ausschaltspannung unter 10 Volt liegen kann. Dieses Schaltverhalten trägt der Tatsache Rechnung, daß bei der Inbetriebnahme eines niederohmigen Endgerätes die Spannung deutlich unter die Einschaltschwelle der Ferntrenneinrichtung absinkt. Die Ansteuerungs-MOS-FETs Q5 und Q10 erzeugen ein Hysterese-Verhalten der Schaltschwelle für die n-Kanal Zweige 101 und 102. Die Kondensatoren CG1 bis CG4, welche zwischen die Source- und Gate-Leitungen der Zweige 100, 101, 102 und 103 geschaltet sind, bewirken ein verzögertes Ausschalten der MOS-FETs und ermöglichen so die Übertragung von Rufwechselströmen.

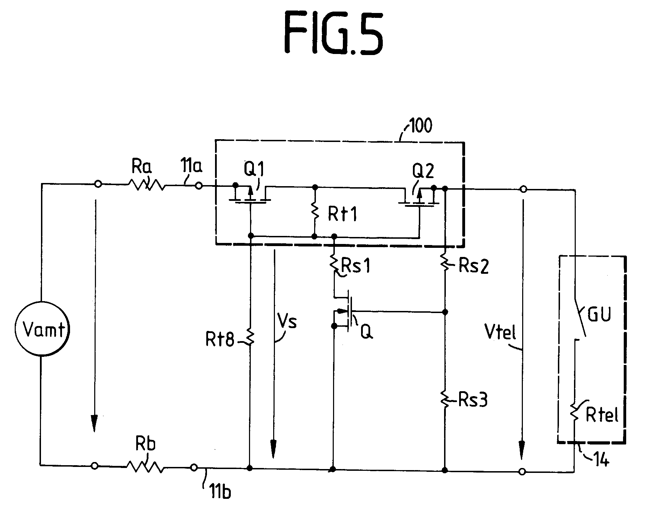

Fig. 5 zeigt eine vereinfachte Teilschaltung der Schaltung nach Fig. 4 und die zugehörige Beschaltung auf der Amt- und der Teilnehmerseite. Anhand Fig. 5 wird die Wirkungsweise der Schaltung gemäß Fig. 4 erklärt. Das Amt besteht, vereinfacht dargestellt, aus einer Gleichspannungsquelle Vamt und zwei Widerständen Ra und Rb, welche die Speise- und Leitung-Widerstände für jede Ader 11a und 11b darstellen. Das Telefon auf der Teilnehmerseite besteht in dieser Vereinfachung aus einem Gabelumschalter GU und einen Widerstand Rtel. Ist der Gabelumschalter GU geöffnet, d.h. der Hörer ist aufgelegt, so steht beim Teilnehmer und damit am Eingang der Ferntrenneinrichtung die volle Speisespannung Vamt zur Verfügung, da die Widerstände Ra und Rb klein gegenüber dem Isolationswiderstand des Telefons 14 sind. Bei geschlossenem Gabelumschalter GU ist das Telefon 14 niederohmig und die Widerstände Ra, Rb und Rtel bilden einen Spannungsteiler, wobei am Telefon 14, je nach Leitungslänge, nur noch 15 bis 30% der Amtsspannung Vamt ansteht. Die Schaltschwelle der Ferntrenneinrichtung darf daher nicht höher als diese Grenze sein und würde bei einer Amtsspannung Vamt von 60V ca. 9V betragen. Es ist jedoch erwünscht im Testfall Messungen mit Spannungen zwische 10 und 20 V durchzuführen, ohne daß der Teilnehmer zugeschaltet wird. Dies ist bei einer einfachen Schaltschwelle von 9V nicht möglich. Es wird daher eine Ansteuerschaltung benötigt, die eine hohe Einschaltschwelle und eine niedrige Ausschaltschwelle hat, d.h. ein Hystereseverhalten aufweist. Die beiden MOS-FETs Q1 und Q2, welche in die Teilnehmerleitung 11a seriell eingeschaltet sind, wobei die jeweiligen Source- und Gate-Anschlüsse miteinander verbunden sind, leiten im eingeschalteten Zustand den Strom zum Telefon 14. Die Ansteuerung des Zweiges 100, gebildet aus Q1 und Q2, erfolgt durch den Spannungsteiler Rt1 und Rt8. Durch diese beiden Widerstände wird die Einschaltschwelle der Schaltung festgelegt und kann beispielsweise bei 50% der Amtsspannung (Speisespannung) liegen. Damit ist die Einschaltschwelle wesentlich größer als die Spannung, die bei geschlossenem Gabelschalter GU noch am Eingang der Ferntrenneinrichtung zur Verfügung stünde. Wird die Einschaltschwelle überschritten, so werden die MOS-FETs Q1 und Q2 leitend und es steht am Ausgang der Ferntrenneinrichtung, also am Spannungsteiler Rs2, Rs3, die gleiche Spannung wie am Eingang derselben an. Der Spannungsteiler Rs2, Rs3 ist so dimensioniert, daß bei kleinen Spannungen von ca 15 bis 20% der Amtsspannung der n-Kanal MOS-FET Q5 leitend ist. Dadurch wird der hochohmige Widerstand Rt8 durch den niederohmige Widerstand Rs1 überbrückt. Die Folge ist, daß, selbst wenn der Gabelumschalter GU geschlossen ist, die MOS-FETs Q1 und Q2 auch bei kleinen Spannungen leitend bleiben. Da sich die MOS-FETs praktisch leistungslos steuern lassen, können die Spannungsteilerviderstände sehr hochohmig, d.h. im MegaOhm Bereich gehalten werden, so daß die Eigenstromaufnahme sehr klein ist.

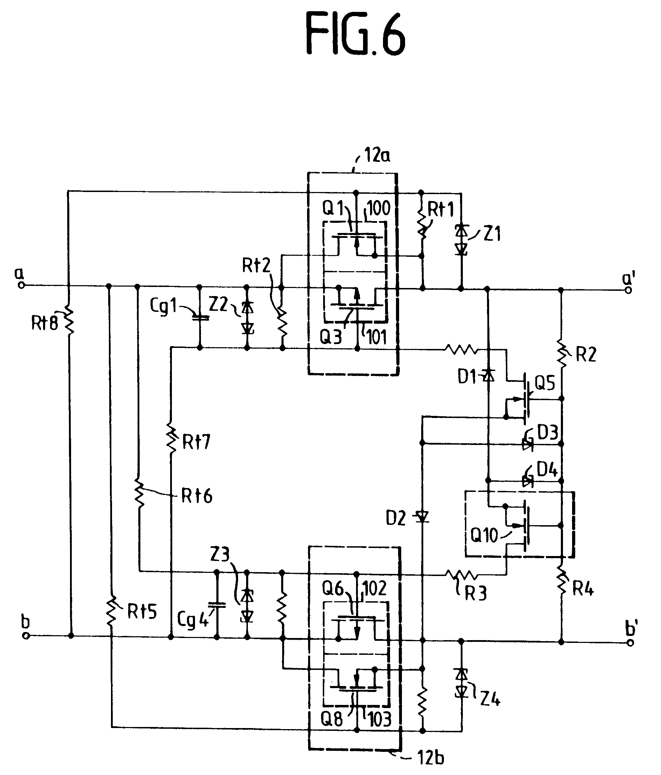

Fig. 6 zeigt eine vereinfachte Ausführungsform der Erfindung, bei der in den Zweigen 100, 101, 102 und 103 statt eines MOS-FET Paares nur jeweils ein einzelner MOS-FET verwendet wird. Die Schalter 12a und 12b bestehen aus je einem n-(Q1,Q8) und einem p-Kanal (Q3,Q6) MOS-FET, die so parallel geschaltet werden, daß die Anoden der Substrat-Dioden zum Teilnehmer hin geschaltet sind. In diesem Fall können die Substratdioden der MOT-FETs nur Strom vom Teilnehmer zur Vermittlungsstelle leiten. Deshalb ist die Schaltschwelle für den Rückflußzweig nicht größer als 0,6V. Ansonsten entspricht der Schaltungaufbau der Ausführungsform gemäß Fig.4.

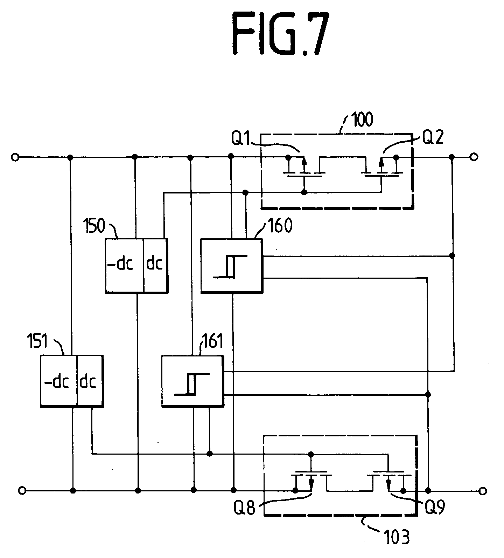

Fig. 7 zeigt eine weitere bevorzugte Ausführungsform der Erindung, wobei die Steuerung der Zweige schematisch dargestellt ist und derjenigen der Ausführungsform gemäß Fig.4 entsprichen. Die n-Kanal MOS-FET Zweige 101 und 102 der Schaltung gemäß Fig. 4 können eingespart werden, wenn die p-Kanal Zweige 100 und 103 zusätzlich zu den oben beschriebenen Ansteuerschaltungen 160,161, die das Hysterese-Verhalten erzeugen, mit jeweils einem DC/DC-Wandler 150,151 angesteuert werden. Der Wandler 150, 160 erzeugt eine negative Spannung, wenn das entsprechende p-Kanal Paar 100, 103 im negativen Zweig der Fernmeldeleitung liegt und Strom von der Endeinrichtung zur Vermittlungsstelle führt. Eine komplementäre Schaltung mit n-Kanal-Schaltern und DC/DC-Wandlern, die ein positives Potential für den n-Kanal-Schalter erzeugen, der im positiven Zweig liegt, ist ebenfalls denkbar.

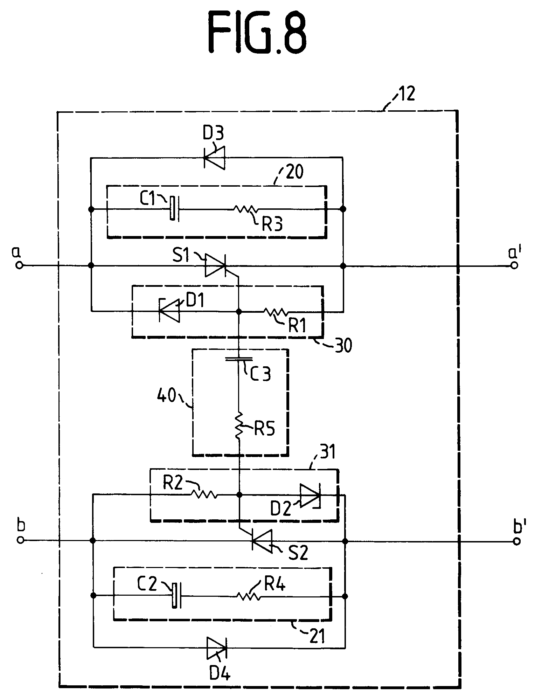

Fig. 8 zeigt eine Ferntrenneinrichtung mit gesteuerten Siliziumgleichrichtern und stellt eine modifizierte Schaltung aus Fig. 2 dar. Der elektronische Schalter 12b in der Ader b ist gegenüber dem Schalter 12a verpolt. Somit ist die Durchlaßrichtung der Dioden D2, D4 und des Thyristors S2 antiparallel gegenüber derjenigen der Dioden D1, D3 und des Thyristors S1 in der Ader a. Bei positiver Spannung der Ader a gegenüber der Ader b sperren die Thyristoren S1 und S2, wenn die Meßspannung unter der Schaltschpannung liegt.Bei negativer Meßspannung werden die Dioden D3 und D4 leitend und die Teilnehmerseite wird in die Messungen mit einbezogen, d.h. die Schalter 12a und 12b werden wieder eingeschaltet.

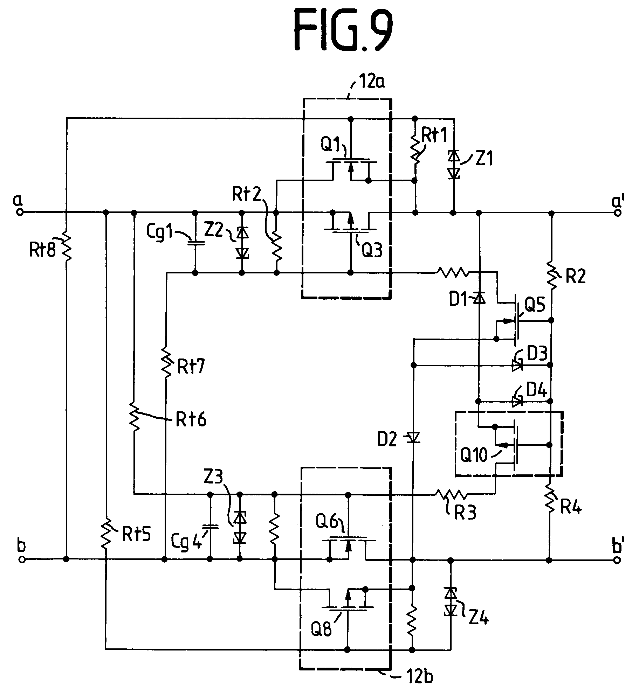

Fig. 9 zeigt die entsprechend modifizierte MOS-FET-Schaltung aus Fig. 6. Dabei sind die MOS-FET-Transistoren in der Ader b vertauscht. Der Transistor Q6 ist nunmehr vom n-Kanal-Typ und der Transistor Q8 vom p-Kanal-Typ. In der Schaltung gemäß Fig. 6 sind die Schalter 12a und 12b demgegenüber symmetrisch. Zusätzlich ist noch der zugehörige Schmitt-Trigger-Transistor Q10 der entsprechenden Ansteuerung gegen den komplementären p-Kanal-Typ ausgetauscht.

## Patentansprüche

1. Ferntrenneinrichtung aus zwei elektronischen, in die jeweilige Teilnehmerleitung (11a, 11b) geschalteten Schaltern (12a,12b), wobei jeder Schalter (12a,12b) einen gesteuerten Siliziumgleichrichter (S1,S2) enthält, dessen Steuereingang durch eine parallel geschaltete Zenerdiode (D1, D2) mit Widerstand (R1,R2) angesteuert wird und eine parallele Überbrückung (20,21) des Siliziumgleichrichters (S1,S2) enthält, welche aus einer Kapazität (C1,C2) und einem Widerstand (R3,R4) besteht,
**dadurch gekennzeichnet,**
daß die Steuereingänge der Siliziumgleichrichter (S1,S2) mittels eines Koppelgliedes (40) verbunden sind.

2. Ferntrenneinrichtung nach Anspruch 1, dadurch gekennzeichnet, daß das Koppelglied (40) aus der Serienschaltung einer Kapazität (C3) und eines Widerstandes (R5) besteht.

3. Ferntrenneinrichtung nach Anspruch 2, dadurch gekennzeichnet, daß die elektronischen Schalter (12a, 12b) mit entgegengesetzter Polung in die Leitungen (11a, 11b) eingesetzt sind.

4. Ferntrenneinrichtung aus zwei elektronischen, in die jeweilige Teilnehmerleitung (11a,11b) geschalteten Schaltern (12a,12b), wobei jeder Schalter (12a,12b) mindestens einen MOS-FET enthält,
**dadurch gekennzeichnet,**
daß selbstsperrende MOS-FETs vom Anreicherungstyp verwendet werden.

5. Ferntrenneinrichtung nach Anspruch 4, dadurch gekennzeichnet, daß die MOS-FET Schalter (12a,12b) so angesteuert werden, daß sie eine hohe Einschaltschwelle und eine niedrige Ausschaltschwelle aufweisen.

6. Ferntrenneinrichtung nach Anspruch 5, dadurch gekennzeichnet, daß die Ansteuerung eines MOS-FET Schalters (12a,12b) aus mindestens einem Spannungsteiler ((Rt1,Rt8), (Rt2,Rt7), (Rt3,Rt6), (Rt4,Rt5) und einem Ansteuerungs-MOS-Fet (Q5,Q10) besteht.

7. Ferntrenneinrichtung nach Anspruch 6, dadurch gekennzeichnet, daß beide Ansteuerungs-MOS-FETs vom gleichen Typ sind.

8. Ferntrenneinrichtung nach Anspruch 7, dadurch gekennzeichnet, daß beide Ansteurungs-MOS-FETs vom n-Kanal-Typ sind.

9. Ferntrenneinrichtung nach einem der Ansprüche 6 bis 8, dadurch gekennzeichnet, daß die Einschaltspannung in der Größenordnung der Speisespannung des Fernmeldenetzes liegt.

10. Ferntrenneinrichtung nach Anspruch 9, dadurch gekennzeichnet, daß die Ausschaltspannung ca. 15% der Speisespannung des Fernmeldenetzes beträgt.

11. Ferntrenneinrichtung nach einem oder mehreren der Ansprüche 5 bis 10, dadurch gekennzeichnet, daß ein MOS-FET Schalter (12a,12b) aus einem n-Kanal (101,102) und einem dazu parallel geschalteten p-Kanal MOS-FET Zweig (100,103) besteht.

12. Ferntrenneinrichtung nach Anspruch 11, dadurch gekennzeichnet, daß zwischen der gemeinsamen Sourceleitung und der Gate-Leitung eines MOS-FET Zweiges (100,101,102,103) Kondensatoren (Cg1,Cg2,Cg3,Cg4) geschaltet sind.

13. Ferntrenneinrichtung nach Anspruch 12, dadurch gekennzeichnet, daß ein MOS-FET Zweig (100,101,102,103) aus einem MOS-FET (Q1,Q3,Q6,Q8) besteht.

14. Ferntrenneinrichtung nach Anspruch 13, dadurch gekennzeichnet, daß die Anoden der Substrat-Dioden zum Teilnehmer hin geschaltet sind.

15. Ferntrenneinrichtung nach Anspruch 11 oder 12, dadurch gekennzeichnet, daß ein MOS-FET Zweig (100,101,102,103) ein Paar MOS-FETs ((Q1,Q2), (Q3,Q4), (Q6,Q7), (Q8,Q9)) enthält.

16. Ferntrenneinrichtung nach Anspruch 15, dadurch gekennzeichnet, daß die Kanalsubstratdioden eines MOS-FET Paares ((Q1,Q2), Q3,Q4), Q6,Q7), Q8,Q9)) gegeneinander geschaltet sind.

17. Ferntrenneinrichtung nach Anspruch 16, dadurch gekennzeichnet, daß jeweils die Gate- und die Source-Anschlüsse eines MOS-FET Paares ((Q1,Q2), Q3,Q4), Q6,Q7), Q8,Q9)) miteinander verbunden sind.

18. Ferntrenneinrichtung nach einem oder mehreren der Ansprüche 5 bis 10, dadurch gekennzeichnet, daß ein MOS-FET Schalter (12a,12b) aus einem p-Kanal Zweig (100,103) besteht, wobei der Zweig ein Paar MOS-FETs ((Q1,Q2), Q8,Q9) enthält, deren jeweilige Gate- und Source-Anschlüsse miteinander verbunden sind.

19. Ferntrenneinrichtung nach Anspruch 18, dadurch gekennzeichnet, daß die Gate-Leitung jedes Zweiges (100,103) zusätzlich durch einen DC/DC-Wandler (150,151) angesteuert wird.

20. Ferntrenneinrichtung nach Anspruch 5, dadurch gekennzeichnet, daß die Einschaltschwelle für negative Spannungen verschieden von derjenigen für positive Spannungen ist.

21. Ferntrenneinrichtung nach Anspruch 20 und einem oder mehreren der Ansprüche 6 und 9 bis 17, dadurch gekennzeichnet, daß einer der beiden Ansteuerungs-MOS-FETS (Q5,Q10) ein p-Kanal-Typ und der andere ein n-Kanal-Typ ist, und daß die MOS-FET-Transistoren (Q1,Q3; Q6,Q8) in einer Ader vertauscht sind.

22. Ferntrenneinrichtung nach einem oder mehreren der vorangegangenen Ansprüche, dadurch gekennzeichnet, daß die Schaltung komplementär aufgebaut ist.
